**Europäisches Patentamt**

**European Patent Office**

**Office européen des brevets**

(19)

(11) Veröffentlichungsnummer: **0 162 363 B1**

(12)

# EUROPÄISCHE PATENTSCHRIFT

(45) Veröffentlichungstag der Patentschrift: **09.10.91**

(51) Int. Cl.⁵: **H03F 1/52**, H03F 3/30

(21) Anmeldenummer: **85105472.6**

(22) Anmeldetag: **04.05.85**

(54) **Schaltungsanordnung gegen Überlastung einer transistorisierten komplementären Gegentakt-Endstufe.**

(30) Priorität: **23.05.84 DE 3419197**

(43) Veröffentlichungstag der Anmeldung:
**27.11.85 Patentblatt 85/48**

(45) Bekanntmachung des Hinweises auf die
Patenterteilung:
**09.10.91 Patentblatt 91/41**

(84) Benannte Vertragsstaaten:
**AT CH DE FR LI NL**

(56) Entgegenhaltungen:
**DE-A- 1 923 036**
**US-A- 3 553 599**
**US-A- 4 237 425**

(73) Patentinhaber: **Deutsche Thomson-Brandt
GmbH
Hermann-Schwer-Strasse 3 Postfach 1307
W-7730 Villingen-Schwenningen(DE)**

(72) Erfinder: **Sternad, Rolf
Breslauerstrasse 11
W-7730 Villingen-Schwenningen(DE)**

EP 0 162 363 B1

## Beschreibung

Die Erfindung geht aus von einer Schaltungsanordnung nach dem Oberbegriff des Patentanspruchs 1.

In der DE-B-1 811 765 ist eine gegen Überlastung geschützte Transistorverstärkerstufe mit einem Schutztransistor beschrieben. Der Schutztransistor begrenzt dabei in kombinierter Abhängigkeit vom Strom und Spannungsabfall der Transistorstufen deren Steuersignal. Hierbei erzeugt ein in die Emitterleitung des Endstufentransistors geschalteter Widerstand einen Spannungsabfall, der bei Überschreiten eines vorbestimmten Wertes den Schutztransistor durchschalte. In der bekannten Schaltung liegen die Kollektoren auf verschiedenen Potentialen und müssen deshalb voneinander isoliert werden.

Da die Kollektoren der Endstufentransistoren mit dem Gehäuse der Transistoren verbunden sind, können sie nicht direkt auf den Kühlkörper aufgeschraubt werden, sondern es muß eine Glimmerscheibe als Isolierung zwischen Kühlkörper und Transistorgehäuse gelegt sein. Dieses vermindert jedoch den Wärmeleitwert, der durch eine Wärmeleitpaste wieder erhöht werden muß. Dieser Nachteil wird auch nicht beseitigt, wenn die Emitter an die Spannungsquelle geschaltet werden und die Kollektoren über Widerstände an die Lastimpedanz gelegt werden. Wegen der Zwischenschaltung der Widerstände als Fühlelement für die Stromüberlastung müssen auch hier die Kollektoren voneinander isoliert auf dem Kühlkörper angeordnet sein.

In der US-A-3 553 599 wird eine Gegentaktendstufe beschrieben, in welcher zwischen die Basen der Treibertransistoren ebenfalls ein Kompensationstransistor geschaltet ist.

Wenn dieser Kompensationstransistor durch irgend einen Störfall nichtleitend wird, kann der Ruhestrom der Endstufe auf unzulässige Werte ansteigen, der diese bis zur Zerstörung erwärmt. Bei der Prüfung nach den VDE-Vorschriften werden z.B. Kurzschlüsse und Unterbrechungen sämtlicher Bauteile der Geräte simuliert, auch z.B. die Unterbrechung eines Widerstandes im Kreis des Kompensationstransistors, wodurch dieser nichtleitend wird und dadurch eine nach den genannten Vorschriften nicht erlaubte Erwärmung der Endstufe stattfindet.

Der Erfindung liegt die Aufgabe zugrunde, eine Erwärmung der Endstufe im Störfall, insbesondere bei der VDE-Prüfung zu vermeiden. Diese Aufgabe wird bei einer Schaltung der im Oberbegriff des Patentanspruchs definierten Art durch die im Kennzeichen des Patenanspruchs angegebene Erfindung gelöst.

Die Erfindung besitzt den Vorteil, daß Thermoschalter auf dem Kühlkörper oder im Netztransformator entfallen können.

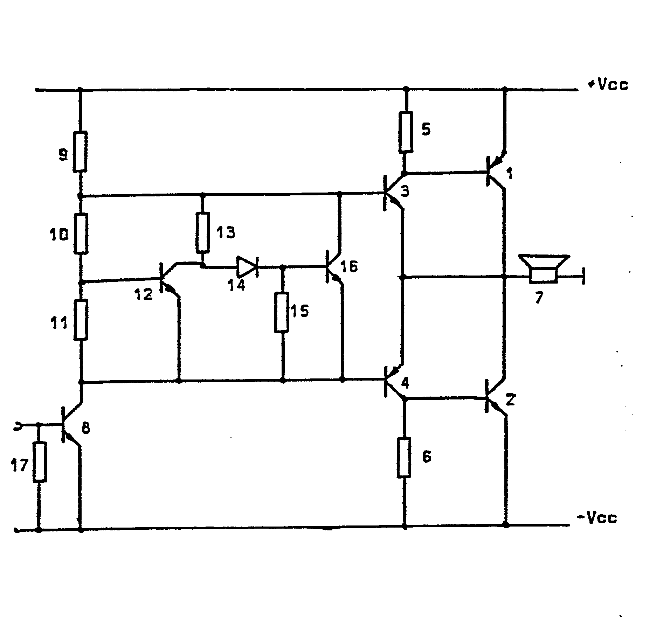

Nachstehend wird die Erfindung mit Hilfe der Zeichnung an einem Ausführungsbeispiel beschrieben.

Zwischen die Betriebsspannungsquelle mit den Polen $+V_{cc}$ und $-V_{cc}$ ist in bekannter Weise ein komplementäres Transistorendstufenpaar 1 und 2 geschaltet, die von Treibertransistoren 3 und 4 gesteuert werden, in deren Kollektorleitungen die Widerstände 5 und 6 geschaltet sind. An den Ausgang mit den auf gleichem Potential liegenden Kollektoren der Endstufentransistoren 1 und 2 ist die Lastimpedanz, z.B. ein Lautsprecher 7, angeschlossen. Das Eingangssignal gelangt vom Widerstand 17 an den Transistor 8 und wird von seinem Arbeitswiderstand 9 im Kollektorkreis und vom Kollektor an die Treibertransistoren 3 und 4 gelegt. Der Ruhestrom wird mit Hilfe eines Potentiometers 11 in Reihe zu einem Widerstand 10 eingestellt. Zwecks Temperaturkompensation ist in engem Wärmekontakt mit den Endstufentransistoren 1 und 2 der Kompensationstransistor 12 zwischen die Basen der Treibertransistoren 3 und 4 geschaltet. Erfindungsgemäß ist in die Kollektorleitung dieses Kompensationstransistors 12 ein Kollektorwiderstand 13 gelegt. Der Kollektor des Kompensationstransistors 12 ist über eine Diode 14 und einen Eingangsbasiswiderstand 15 mit dem Emitter des Transistors 12 verbunden. Die Verbindung zwischen der Diode 14 und dem Eingangsbasiswiderstand 15 ist an die Basis des Schutztransistors 16 geschaltet, dessen Kollektor-Emitter-Strecke die Basen der Treibertransistoren 3 und 4 verbindet. Wird z.B. der Kompensationstransistor 12 in den gesperrten Zustand gebracht, z.B. durch eine Unterbrechung des Widerstandes 10, was bei einer Freigabeprüfung nach den VDE-Vorschriften der Fall ist, würden ohne die im Patentanspruch 1 angegebene Maßnahme die Endstufentransistoren 1 und 2 einen unzulässig hohen Strom aufnehmen. Der eingeschaltete Schutztransistor 15 verhindert jedoch diesen Zustand, da bei gesperrtem Transistor 12 die über dem Kollektorwiderstand 13 und die Diode 14 an die Basis des Schutztransistors 16 gelangende positive Spannung diesen durchschaltet. Der Kollektorwiderstand 13 ist derart bemessen, daß die Emitter-Kollektor-Spannung des Transistors 12 etwa 0,6 Volt beträgt. Daher wird die Schwellenspannung der in Serie liegenden Diode 14 und der Basis-Emitter-Diode des Transistors 16 im normalen Betriebsfall nicht überschritten.

## Patentansprüche

1. Schaltungsanordnung gegen Überlastung einer transistorisierten komplementären Gegentakt-B-Endstufe, deren Endtransistoren (1, 2) mit ihren Kollektoren zusammen an eine Lastimpedanz (7) und deren Emitter an je einen Pol (+Vcc, -Vcc) einer Betriebsspannungsquelle angeschaltet sind und deren Basen mit den Kollektorarbeitswiderständen (5, 6) von Treibertransistoren (3, 4) verbunden sind, deren Basen über die Kollektor-Emitter-Strecke eines Kompensationstransistors (12) zusammengeschaltet sind, sowie mit einem Schutztransistor (16), **dadurch gekennzeichnet,** daß in die Kollektorleitung des Kompensationstransistors (12) ein Kollektorwiderstand (13) eingeschaltet ist und daß parallel zur Kollektor-Emitter-Strecke des Kompensationstransistors (12) die Serienschaltung einer Diode (14) mit einem zwischen Basis und Emitter des Schutztransistors (16) liegenden Eingangsbasiswiderstand (15) geschaltet ist, wobei der Verbindungspunkt von Diode (14) und Eingangsbasiswiderstand (15) mit der Basis des Schutztransistors (16) verbunden ist, dessen Kollektor-Emitter-Strecke die Basen der Treibertransistoren (3, 4) miteinander verbindet.

2. Schaltungsanordnung nach Anspruch 1, **dadurch gekennzeichnet,** daß der Kollektorwiderstand (13) derart bemessen ist, daß die Kollektor-Emitter-Spannung des Kompensationstransistors (12) kleiner ist als die Schwellenspannung der zum Kollektorwiderstand (13) in Serie geschalteten Diode (14) und der Basis-Emitter-Diode des Schutztransistors (16).

**Claims**

1. Circuit device against overload of a complementary transistorized B-push-pull power stage, the output transistors (1, 2) of which are both connected by their collectors to a load impedance (7) and the emitters of which are connected to respectively one pole (+$V_{cc}$, -$V_{cc}$) of an operating voltage source and the bases of which are connected to the collector load resistors (5, 6) of driving transistors (3, 4), the bases of which are interconnected over the collector-emitter-path of a compensation transistor (12), as well as with a protection transistor (16), **characterized in that** a collector resistor (13) is connected into the collector line of the compensation transistor (12) and that the series connection of a diode (14) with an input base resistance (15) placed between the base and the emitter of the protection transistor (16) is connected in parallel with the collector-emitter path of the compensation transistor (12), the connecting point of diode (14) and input base resistor (15) being connected to the base of the protection transistor (16), the collector-emitter path of which connects the bases of the driving transistors (3, 4) to each other.

2. Circuit device according to claim 1, **characterized in that** the collector resistor (13) is dimensionned to make the collector-emitter-voltage of the compensation transistor (12) less that the threshold voltage of the diode (14) connected in series to the collector resistor (13) and of the base-emitter diode of the protection transistor (16).

**Revendications**

1. Montage contre la surcharge d'un étage final symétrique type B complémentaire transistorisé dont les transistors finaux (1, 2) sont montés simultanément avec leurs collecteurs sur une impédance de charge (7) et dont les émetteurs sont montés chacun sur un pôle (+$V_{cc}$, -$V_{cc}$) d'une source de tension de fonctionnement et dont les base sont reliées aux résistances de charge des collecteurs (5, 6) de transistors d'attaque (3, 4) dont les bases sont interconnectées par la voie collecteur-émetteur d'un transistor de compensation (12), ainsi qu'avec un transistor de protection (16), **caractérisé en ce qu'une** résistance collecteur (13) est mise en circuit dans la ligne collecteur du transistor de compensation (12) et que le montage en série d'une diode (14) avec une résistance base d'entrée (15) placée entre la base et l'émetteur du transistor de protection (16) est monté parallèlement à la voie collecteur-émetteur du transistor de compensation (12), le point de connexion de la diode (14) et de la résistance base d'entrée (15) étant relié à la base du transistor de protection (16) dont la voie collecteur-émetteur relie les bases des transistors d'attaque (3, 4) l'une à l'autre.

2. Montage selon la revendication 1, **caractérisé en ce que** la résistance collecteur (13) est dimensionnée de telle manière que la tension collecteur-émetteur du transistor de compensation (12) est inférieure à la tension de seuil de la diode (14) montée en série avec la résistance collecteur (13) et de la diode émetteur de la base du transistor de protection (16).